# FASCICULE DE BREVET EUROPEEN

(11) **EP 2 872 444 B1**
(45) Date de publication et mention de la délivrance du brevet: **13.09.2017**
(21) Numéro de dépôt: 13742173.1
(22) Date de dépôt: 05.07.2013
(51) Int. Cl.: C01B 33/029, C01B 32/05, C01B 33/02, C01B 33/027, C23C 16/44, B82Y 30/00, B01J 19/08

(54) **PROCEDE DE FABRICATION PAR PYROLYSE LASER DE PARTICULES SUBMICRONIQUES MULTICOUCHES**
VERFAHREN ZUR HERSTELLUNG MEHRSCHICHTIGER SUBMIKRONPARTIKEL DURCH LASERPYROLYSE
METHOD FOR PRODUCING MULTILAYER SUBMICRON PARTICLES BY LASER PYROLYSIS

(30) Priorité: 12.07.2012 FR 1256710
(43) Date de publication de la demande: 20.05.2015
(73) Titulaire: Nanomakers, 78120 Rambouillet (FR)
(72) Inventeur: TENEGAL, François, 75014 Paris (FR)
(74) Mandataire: Pontet Allano & Associes
(86) Numéro de dépôt international: PCT/EP2013/064232
(87) Numéro de publication internationale: WO 2014/009265

(56) Documents cités:
- US-A1- 2004 229 447
- US-A1- 2009 026 421
- HUISKEN F ET AL: "Silicon Carbide Nanoparticles Produced by CO2 Laser Pyrolysis of SiH4/C2H2 Gas Mixtures in a Flow Reactor", JOURNAL OF NANOPARTICLE RESEARCH, KLUWER ACADEMIC PUBLISHERS, DORDRECHT, NL , vol. 1 1 janvier 1999 (1999-01-01), pages 293-303, XP002528435, ISSN: 1388-0764, DOI: 10.1023/A:1010081206959 Extrait de l'Internet: URL:http://www.springerlink.com/content/v8 598045011t4gv8/ [extrait le 2009-05-18]

## Description

### Domaine technique

La présente invention concerne un procédé de fabrication de particules multicouches (typiquement une couche de coeur recouverte d'une couche supérieure), typiquement par pyrolyse laser. Elle concerne aussi un dispositif associé.

Un tel procédé permet par exemple à un utilisateur de fabriquer des particules submicroniques de silicium recouvertes chacune d'une couche de carbone.

### Etat de la technique antérieure

On connaît un procédé pour fabriquer des particules d'oxyde de silicium recouvertes d'une couche de carbone par pyrolyse laser tel que décrit dans le document US6, 387,531.

Cependant, un tel procédé possède quelques inconvénients :
- les types et le nombre possible d'utilisations de ces particules sont limités, et on pourrait chercher à fabriquer des particules permettant de nouvelles utilisations, et
- l'homogénéité de répartition et d'épaisseur de la couche de carbone sur chaque coeur de particule en silicium est améliorable.

US 2009/0026421 décrit un procédé de fabrication dans lequel deux éléments chimiques sont mélangés par faisceaux croisés avant une zone d'interaction avec un laser.

US 2004/0229447 décrit une fabrication de cours de particules dans un réacteur. Après cette fabrication, c'est-à-dire en dehors du réacteur, on fait un traitement de surface des particules avec de l'octadécène.

Le but de l'invention est de résoudre au moins un ou plusieurs des inconvénients listés ci-dessus.

### Exposé de l'invention

Cet objectif est atteint avec un procédé pour produire des particules, comprenant les étapes suivantes :
- Introduire dans une chambre de réaction au moins un flux de réaction comprenant un premier élément chimique (typiquement du silicium) et se propageant selon une direction de flux,
- Projeter un faisceau de rayonnement à travers la chambre de réaction en intersection avec chaque flux de réaction dans une zone d'interaction par flux de réaction, pour former dans chaque flux de réaction des coeurs de particules comprenant le premier élément chimique, et
- Introduire, dans la chambre de réaction, un deuxième élément chimique (typiquement carbone) interagissant avec chaque flux de réaction pour recouvrir les coeurs de particules d'une couche comprenant le deuxième élément chimique
chaque flux de réaction étant dénué d'agent oxydant le premier élément chimique, et les coeurs de particules comprenant le premier élément chimique sous forme non oxydée, le nombre d'atomes introduits du deuxième élément par rapport au nombre d'atomes introduits du premier élément correspondant à un rapport de un atome du deuxième élément introduit par unité de temps pour au moins deux atomes du premier élément introduit par unité de temps, le deuxième élément chimique étant introduit dans la chambre dans un flux de gaz entourant chaque flux de réaction, caractérisé en ce que :
- le deuxième élément chimique est introduit dans la chambre dans un flux de gaz de périphérie entourant chaque flux de réaction, émis à partir de plusieurs points répartis le long d'une courbe fermée entourant chaque flux de réaction et se propageant en direction de chaque flux de réaction, le deuxième élément chimique étant introduit dans la chambre dans le flux de gaz de périphérie après la zone d'interaction de chaque flux de réaction, et/ou
- il comprend en outre comme étape introduire dans la chambre de réaction, avant la zone d'interaction de chaque flux de réaction, un flux de gaz de confinement entourant chaque flux de réaction et se propageant selon la direction de flux, le deuxième élément chimique étant introduit dans la chambre dans le flux de gaz de confinement avant la zone d'interaction de chaque flux de réaction.

Ainsi, en se passant d'agent oxydant agencé pour oxyder le premier élément chimique, on peut obtenir des particules dont le coeur comprend le premier élément non oxydé. La couche de deuxième élément protège le coeur de l'oxydation, et permet :
- de conserver le premier élément dans un état non oxydé, ce qui laisse plus de choix pour les utilisations possibles des particules fabriquées : soit conserver le premier élément du coeur non oxydé pour des nouvelles utilisations de particules non oxydées, soit retirer la couche de deuxième élément (par exemple par recuit sous atmosphère contrôlée de particules de silicium non oxydées recouvertes d'une couche de carbone, fournissant des particules de silicium (oxydées ou non) sans couche de carbone et dégageant du CO₂) pour permettre une utilisation du premier élément sous forme pure en vue d'autres utilisations plus classiques, et
- d'éviter des effets d'auto inflammation du coeur (par exemple silicium non oxydé) par de l'oxygène ambiant.

Ainsi, un tel procédé selon l'invention permet par exemple à un utilisateur de fabriquer des particules submicroniques de silicium non oxydé recouvertes chacune d'une couche de carbone protectrice empêchant toute oxydation du coeur de silicium de chacune des particules.

Pour un rapport moindre (par exemple un atome du deuxième élément de Carbone introduit dans un flux de réaction par unité de temps pour un atome du premier élément de Silicium introduit par unité de temps dans ce flux de réaction), la réaction serait différente (par exemple obtention de particules en carbure de Silicium)

Le deuxième élément chimique est introduit dans la chambre dans un flux de gaz entourant chaque flux de réaction.

Ce mode de réalisation améliore de manière significative l'homogénéité de répartition et d'épaisseur de la couche de deuxième élément sur chaque coeur de particule. En effet, on a remarqué que, dans le cas où le deuxième élément chimique est introduit dans la chambre avec le premier élément chimique dans chaque flux de réaction, l'homogénéité de répartition et d'épaisseur de la couche de deuxième élément sur chaque coeur de particule n'est pas parfaite, surtout si dans chaque flux de réaction on se passe d'agent agencé pour oxyder le premier élément chimique.

Le deuxième élément chimique peut être introduit dans la chambre dans un flux de gaz de périphérie entourant chaque flux de réaction, émis à partir de plusieurs points répartis le long d'une courbe fermée entourant chaque flux de réaction et se propageant en direction de chaque flux de réaction. Le deuxième élément chimique est de préférence introduit dans la chambre dans le flux de gaz de périphérie après la zone d'interaction de chaque flux de réaction.

Le procédé selon l'invention peut comprendre en outre comme étape introduire dans la chambre de réaction, avant la zone d'interaction de chaque flux de réaction, un flux de gaz de confinement entourant chaque flux de réaction et se propageant selon la direction de flux. Le deuxième élément chimique peut être introduit dans la chambre dans le flux de gaz de confinement avant la zone d'interaction de chaque flux de réaction.

L'introduction d'au moins un flux de réaction peut comprendre une introduction d'au moins un alignement de plusieurs flux de réaction séparés les uns des autres par le flux de gaz de confinement et comprenant chacun le premier élément chimique et se propageant chacun selon la direction de flux.

Le faisceau de rayonnement peut se propager le long d'une direction de rayonnement de préférence perpendiculaire à la direction de flux, et les flux de chaque alignement de flux de réaction peuvent être alignés le long d'une direction d'alignement perpendiculaire à la direction de flux et à la direction de rayonnement.

Le faisceau de rayonnement peut se propager le long d'une direction de rayonnement de préférence perpendiculaire à la direction de flux, et chaque flux de réaction peut posséder, dans un plan perpendiculaire à la direction de flux, une section s'étendant longitudinalement le long d'une direction d'élongation perpendiculaire à la direction de flux et à la direction de rayonnement.

Le deuxième élément chimique peut être introduit dans la chambre avec le premier élément chimique dans chaque flux de réaction avant la zone d'interaction de chaque flux de réaction.

Le premier élément chimique est de préférence du silicium.

Le premier élément chimique est de préférence introduit dans la chambre sous la forme de SiH₄.

Les coeurs de particules peuvent être en silicium.

Le deuxième élément est de préférence du carbone.

Suivant encore un autre aspect de l'invention, il est proposé des particules comprenant chacune:
- un coeur comprenant (de préférence consistant uniquement en) comme premier élément chimique du silicium non oxydé, ayant un diamètre compris entre 3 et 900 nm (de préférence avec un écart type entre 1 et 90 nm), et
- une couche entourant le coeur, consistant uniquement en un deuxième élément chimique de Carbone et ayant une épaisseur (pas nécessairement homogène) de couche d'au moins 0.5 nm, de préférence entre 0.5 et 10 nm.

Suivant encore un autre aspect de l'invention, il est proposé un dispositif pour produire des particules, comprenant:
- une source de réactif comprenant du réactif, ce réactif comprenant un premier élément chimique ;
- une chambre de réaction reliée à la source de réactif ;
- un injecteur de réactif agencé pour introduire, dans la chambre et en provenance de la source de réactif, au moins un flux de réaction comprenant ledit réactif et se propageant selon une direction de flux dans une zone de flux de réaction par flux de réaction,
- un émetteur d'un faisceau de rayonnement agencé pour projeter le faisceau de rayonnement à travers la chambre de réaction en intersection avec chaque zone de flux de réaction dans une zone d'interaction par flux de réaction,
- une source d'un deuxième élément chimique, et
- un injecteur de deuxième élément agencé pour introduire, dans la chambre de réaction, le deuxième élément chimique à partir de la source de deuxième élément de sorte que ce deuxième élément chimique soit apte à interagir dans le chambre avec chaque flux de réaction
le réactif étant dénué d'agent oxydant le premier élément chimique, l'injecteur de deuxième élément et l'injecteur de premier élément étant agencés ensemble pour introduire un nombre d'atomes du deuxième élément par rapport à un nombre d'atomes du premier élément selon un rapport de un atome du deuxième élément pour au moins deux atomes du premier élément, l'injecteur de deuxième élément chimique étant agencé pour introduire le deuxième élément chimique dans la chambre dans un flux de gaz entourant chaque flux de réaction, caractérisé en ce que :
- l'injecteur de deuxième élément chimique est agencé pour introduire le deuxième élément chimique dans la chambre dans un flux de gaz de périphérie entourant chaque flux de réaction, émis à partir de plusieurs points répartis le long d'une courbe fermée entourant chaque flux de réaction et agencés pour diriger le flux de gaz de périphérie en direction de chaque flux de réaction, l'injecteur de deuxième élément chimique étant agencé pour introduire le deuxième élément chimique dans la chambre dans le flux de gaz de périphérie après la zone d'interaction de chaque flux de réaction, et/ou
- il comprend en outre un injecteur de gaz de confinement agencé pour introduire dans la chambre de réaction, avant la zone d'interaction de chaque flux de réaction, un flux de gaz de confinement entourant chaque flux de réaction et se propageant selon la direction de flux, et en ce que l'injecteur de deuxième élément chimique comprend l'injecteur de gaz de confinement.

L'injecteur de deuxième élément chimique peut être agencé pour introduire le deuxième élément chimique dans la chambre dans un flux de gaz de périphérie entourant chaque flux de réaction, émis à partir de plusieurs points répartis le long d'une courbe fermée entourant chaque flux de réaction et agencés pour diriger le flux de gaz de périphérie en direction de chaque flux de réaction. L'injecteur de deuxième élément chimique peut être agencé pour introduire le deuxième élément chimique dans la chambre dans le flux de gaz de périphérie après la zone d'interaction de chaque flux de réaction.

Le dispositif selon l'invention peut comprendre en outre un injecteur de gaz de confinement agencé pour introduire dans la chambre de réaction, avant la zone d'interaction de chaque flux de réaction, un flux de gaz de confinement entourant chaque flux de réaction et se propageant selon la direction de flux. L'injecteur de deuxième élément chimique peut comprendre l'injecteur de gaz de confinement.

L'injecteur d'au moins un flux de réaction peut être agencé pour introduire dans la chambre au moins un alignement de plusieurs flux de réaction séparés les uns des autres par le flux de gaz de confinement et comprenant chacun le premier élément chimique et se propageant chacun selon la direction de flux.

L'émetteur peut être agencé pour que le faisceau de rayonnement se propage le long d'une direction de rayonnement de préférence perpendiculaire à la direction de flux, et l'injecteur d'au moins un flux de réaction peut être agencé pour que les flux de chaque alignement de flux de réaction soient alignés le long d'une direction d'alignement perpendiculaire à la direction de flux et à la direction de rayonnement.

L'émetteur peut être agencé pour que le faisceau de rayonnement se propage le long d'une direction de rayonnement de préférence perpendiculaire à la direction de flux, et l'injecteur d'au moins un flux de réaction peut être agencé pour que chaque flux de réaction possède, dans un plan perpendiculaire à la direction de flux, une section s'étendant longitudinalement le long d'une direction d'élongation perpendiculaire à la direction de flux et à la direction de rayonnement.

L'injecteur de deuxième élément chimique peut être agencé pour introduire le deuxième élément dans la chambre avec le premier élément chimique dans chaque flux de réaction avant la zone d'interaction de chaque flux de réaction.

### Description des figures et modes de réalisation

D'autres avantages et particularités de l'invention apparaîtront à la lecture de la description détaillée de mises en oeuvre et de modes de réalisation nullement limitatifs, et des dessins annexés suivants :
- la figure 1 est une vue schématique de coupe de profil d'un flux de réaction (indifféremment le flux 1, 100, 101, 102, 103, 104, 105 ou 106 selon la variante considérée) dans un dispositif selon l'invention,
- la figure 2 est une vue schématique de coupe (indifféremment au niveau du flux 1, 101, 102, ou 103 selon la variante considérée) de profil d'un dispositif selon l'invention,
- la figure 3 est une vue schématique de coupe de face d'un alignement de flux de réaction 101, 102, 103 dans un dispositif selon l'invention,
- la figure 4 est une vue schématique de coupe (indifféremment au niveau des flux 1, 100 ou 101, 104 ou 102, 105 ou 103, 106 selon la variante considérée) de profil d'une variante de dispositif selon l'invention,
- la figure 5 est une vue en perspective d'un flux de réaction 1 accompagné d'un autre flux de réaction 100 optionnel,
- la figure 6 est une vue en perspective d'un premier alignement de flux de réaction 101, 102, 103 accompagné d'un autre alignement de flux de réaction 104, 105, 106 optionnel,
- la figure 7 est une vue schématique de coupe de profil d'un flux de réaction (indifféremment le flux 1, 100, 101, 102, 103, 104, 105 ou 106 selon la variante considérée) et d'un injecteur 22 annulaire agencé pour diffuser un flux de gaz de périphérie 7,
- la figure 8 est une vue schématique en perspective d'un flux de réaction (indifféremment le flux 1, 100, 101, 102, 103, 104, 105 ou 106 selon la variante considérée) et de l'injecteur annulaire 22,
- la figure 9 est une vue schématique de coupe de profil d'une particule fabriquée, et
- la figure 10 est une vue schématique de coupe de profil d'une autre particule fabriquée selon l'invention.

Ces modes de réalisation étant nullement limitatifs, on pourra notamment considérer des variantes de l'invention ne comprenant qu'une sélection de caractéristiques décrites par la suite isolées des autres caractéristiques décrites (même si cette sélection est isolée au sein d'une phrase comprenant ces autres caractéristiques), si cette sélection de caractéristiques est suffisante pour conférer un avantage technique ou pour différencier l'invention par rapport à de l'état de la technique antérieure. Cette sélection comprend au moins une caractéristique de préférence fonctionnelle sans détails structurels, ou avec seulement une partie des détails structurels si cette partie uniquement est suffisante pour conférer un avantage technique ou à différencier l'invention par rapport à l'état de la technique antérieure.

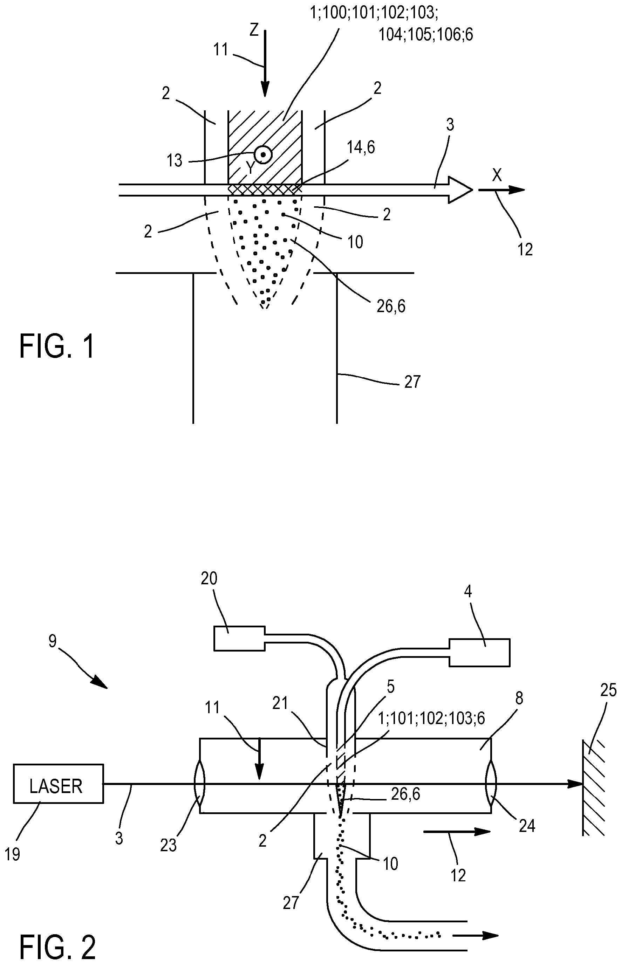

On va tout d'abord décrire, en référence aux figures 1 à 6, un premier mode de réalisation de dispositif 9.

Ce premier mode de réalisation de dispositif 9 pour produire par pyrolyse laser des particules 10 comprend une source 4 de réactif. Le réactif comprend de préférence au moins un gaz de réaction et/ou au moins un liquide de réaction sous forme d'aérosol. Le réactif comprend un premier élément chimique. Le premier élément chimique est de préférence un métal (de préférence parmi le Fer, l'Aluminium, le Titane) ou un métalloïde (parmi du Bore, du Silicium, du Germanium, de l'Arsenic, de l'Antimoine, du Tellure, du Polonium). Plus précisément, le premier élément chimique dans le réactif est de préférence du silicium, de préférence sous la forme de SiH₄. Le réactif est de préférence du gaz de réaction (typiquement du gaz de SiH₄ ou du gaz SiH₄+C₂H₂ ou SiH₄+C₂H₄ ou de SiH₄+CH₄).

Le dispositif 9 comprend en outre une chambre de réaction 8 (délimitée par des parois en inox) reliée à la source 4 de réactif.

La chambre de réaction 8 est remplie d'une atmosphère de gaz neutre (parmi hélium, argon, krypton, xénon, azote ou un mélange), de préférence d'Argon ou d'Azote.

Un injecteur 5 de réactif est agencé pour introduire, dans la chambre 8 et en provenance de la source 4 de réactif, au moins un flux de réaction 1, 100, 101, 102, 103, 104, 105, 106, chaque flux de réaction se propageant selon une direction de flux 11 identique pour tous les flux de réaction et dans une zone 6 de flux de réaction par flux de réaction.

Un émetteur 19 (typiquement une source LASER) d'un faisceau de rayonnement 3 (typiquement un faisceau laser, de préférence d'aire entre 30 mm² et 3000 mm²en coupe perpendiculairement à la direction 12, de largeur le long de la direction 13, 18 comprise entre 2 et 5 cm, de longueur d'onde comprise entre 9 microns et 11 microns de préférence 10.6 microns pour le SiH₄ et de puissance comprise entre 50 et 5000 watt et de fréquence comprise entre 10000 et 100000 Hz) est agencé pour projeter le faisceau de rayonnement 3 à travers la chambre de réaction 8 de sorte que ce faisceau 3 soit en intersection, dans une zone d'interaction 14 par zone 6 de flux de réaction, avec chaque zone 6 de flux de réaction de manière à former dans chaque flux de réaction des coeurs de particules 15 comprenant le premier élément chimique.

Ainsi, chaque flux de réaction 1, 100, 101, 102, 103, 104, 105, 106 ou zone 6 de flux de réaction se décompose en trois parties :
- une zone d'interaction 14 avec le faisceau 3,
- une partie située avant (par rapport à direction de flux 11) sa zone d'interaction 14 et comprenant le réactif tel qu'introduit dans la chambre 8, et
- une partie située après (par rapport à direction de flux 11) sa zone d'interaction 14 et comprenant une flamme 26 issue de l'interaction entre le réactif et le faisceau 3 dans sa zone d'interaction 14.

Le faisceau 3 est mis en forme par un système optique pour lui donner une section rectangulaire focalisée (i.e. dont l'aire diminue avec la progression du faisceau 3 selon la direction de rayonnement 12), comme décrit dans les documents FR 2 894 493 et FR 2 877 591.

Le faisceau 3 entre dans la chambre 8 à travers une fenêtre 23 en ZnSe et ressort de la chambre 8 à travers une autre fenêtre 24 en ZnSe avant d'être arrêté par un calorimètre 25 non réflecteur (« beam stopper »).

Le dispositif 9 comprend en outre une source d'un deuxième élément chimique. Le deuxième élément chimique est de préférence du carbone injecté sous forme de C₂H₂ ou de C₂H₄ ou de CH₄ gazeux. Un injecteur de deuxième élément est agencé pour introduire, dans la chambre de réaction 8, le deuxième élément chimique à partir de la source de deuxième élément de sorte que ce deuxième élément chimique soit apte à interagir dans la chambre 8 avec chaque flux de réaction 1, 100 101, 102, 103, 104, 105, 106 de manière à recouvrir les coeurs de particules 15 d'une couche 16 comprenant le deuxième élément chimique.

Le réactif dans la source 4 et injecté dans la chambre 8 est dénué d'agent oxydant agencé pour oxyder le premier élément chimique. On entend par « agent agencé pour oxyder le premier élément chimique » (aussi appelé « agent oxydant du premier élément chimique ») tout atome ou molécule (par exemple N₂O) qui, dans le réactif (par exemple un gaz de SiH₄, éventuellement mélangé à du C₂H₂ ou du C₂H₄ ou du CH₄), possède un potentiel d'oxydo-réduction tendant à une oxydation du premier élément chimique (par exemple Si) à partir de la forme (par exemple SiH₄) dans laquelle il est injecté dans la chambre 8. De préférence, le réactif dans la source 4 et injecté dans la chambre 8 est dénué d'atome d'oxygène.

L'injecteur (5, 21 et/ou 22) de deuxième élément et l'injecteur 5 de premier élément sont au sein du dispositif 9 agencés ensemble (par leur débit et leurs proportions des différents gaz éventuellement mélangés qu'ils débitent tel que SiH₄ pour l'injecteur 5, argon ou azote pour l'injecteur 21 et C₂H₂, C₂H₄, CH₄ pour l'injecteur 5 et/ou 21 et/ou 22) pour introduire par unité de temps (typiquement par minute) un nombre d'atomes du deuxième élément par rapport à un nombre d'atomes du premier élément selon un rapport de un atome du deuxième élément (typiquement Carbone) introduit (dans la somme des flux de réaction 1, 100, 101, 102, 103, 104, 105, 106, de confinement 2 et éventuellement s'ils existent des flux de périphérie 7) par unité de temps pour au moins deux (de préférence au moins 3, de manière optimale au moins 5) atomes du premier élément (Typiquement Silicium) introduit (dans le flux 1) par unité de temps.

Typiquement, l'injecteur (5, 21 et/ou 22) de deuxième élément et l'injecteur 5 de premier élément sont au sein du dispositif 9 agencés ensemble pour introduire un rapport de un atome du deuxième élément (typiquement Carbone) (dans la somme des flux de réaction 1, 100, 101, 102, 103, 104, 105, 106, de confinement 2 et éventuellement s'ils existent des flux de périphérie 7) par unité de temps pour deux (de préférence trois, de manière optimale cinq) à cinquante atomes du premier élément (Typiquement Silicium) par unité de temps (dans le flux 1).

Le dispositif 9 comprend en outre une source 20 de gaz de confinement comprenant du gaz de confinement et un injecteur 21 de gaz de confinement agencé pour introduire dans la chambre de réaction 8, avant (par rapport à direction de flux 11) la zone d'interaction 14 de chaque flux de réaction, un flux de gaz de confinement 2 (de préférence commun à tous les flux de réaction) entourant chaque flux de réaction 1, 100 101, 102, 103, 104, 105, 106 (plus exactement en contact avec chaque flux de réaction 1, 100, 101, 102, 103, 104, 105, 106 sur tout le pourtour de chaque flux de réaction 1, 100, 101, 102, 103, 104, 105, 106 au moins à partir de l'injection du réactif dans la chambre 8 jusqu'à la zone d'interaction 14 de chaque flux de réaction, ce pourtour étant défini selon une ligne fermée contenue dans un plan perpendiculaire à la direction de flux 11) et se propageant selon la direction de flux 11.

Le gaz de confinement comprend un gaz neutre (parmi hélium, argon, azote ou un mélange de ceux-ci, de préférence de l'argon ou de l'azote). Le flux de gaz de confinement 2 possède deux fonctions :
- d'une part, il sert à confiner chaque flux de réaction pour éviter que les réactifs de chaque flux de réaction diffusent de manière radiale, ce qui risquerait de salir les parois intérieures de la chambre 8, et
- d'autre part, de refroidir (« effet de trempe ») chaque flamme 26 de flux de réaction créée après (par rapport à direction de flux 11) l'interaction du faisceau 3 avec respectivement chaque flux de réaction 1, 100, 101, 102, 103, 104, 105, 106.

L'émetteur 19 est agencé pour que le faisceau de rayonnement 3 se propage le long d'une direction de rayonnement 12 perpendiculaire à la direction de flux 11.

L'injecteur 5 d'au moins un flux de réaction 1, 100, 101, 102, 103, 104, 105, 106 est agencé pour que chaque flux de réaction 1, 100, 101, 102, 103, 104, 105, 106 possède, dans un plan perpendiculaire à la direction de flux 11, une section s'étendant longitudinalement le long d'une direction d'élongation 13 perpendiculaire à la direction de flux 11 et à la direction de rayonnement 12.

Dans une première variante du premier mode de réalisation de dispositif 9 qui peut correspondre à la vue de coupe de la figure 2, l'injecteur 5 de réactif est agencé pour introduire dans la chambre 8, et en provenance de la source 4 de réactif, un unique flux de réaction 1 se propageant selon la direction de flux 11 dans une zone 6 de flux de réaction. La section de l'injecteur 5 est typiquement un ovale de 4 mm de profondeur le long de la direction 12 et de 2 cm de large le long de la direction 13.

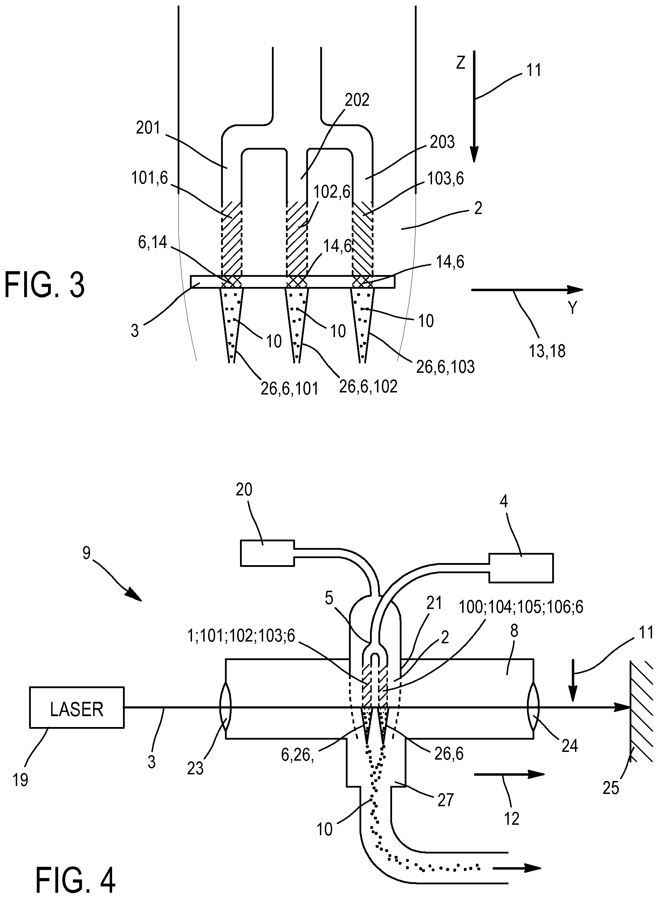

Dans une deuxième variante du premier mode de réalisation de dispositif 9 qui peut correspondre à la vue de coupe de profil de la figure 2 et de la vue de coupe de face de la figure 3, l'injecteur 5 d'au moins un flux de réaction est agencé pour introduire, dans la chambre 8 et en provenance de la source 4 de réactif, un alignement de plusieurs flux de réaction 101, 102, 103 séparés les uns des autres par le flux de gaz de confinement 2 et comprenant chacun le premier élément chimique et se propageant chacun selon la direction de flux 11.

Chaque flux 101, 102 ou 103 se propage selon la direction de flux 11 dans une zone 6 de flux de réaction qui lui est propre.

L'injecteur 5 d'au moins un flux de réaction 101, 102, 103 est agencé pour que, au sein de l'alignement de flux 101, 102, 103, les différents flux de réaction 101, 102, 103 soient alignés le long d'une direction d'alignement 18 perpendiculaire à la direction de flux 11 et à la direction de rayonnement 12.

Comme illustré sur la figure 3, l'injecteur 5 se subdivise en plusieurs buses d'injection 201, 202, 203 (une buse par flux de réaction). Chaque buse a une section qui est typiquement un ovale de 3 mm de profondeur le long de la direction 12 et de 4 mm de large le long de la direction 13, 18. Le nombre de flux de réaction 101, 102, 103 et de buses 201, 202, 203 n'est pas du tout limité à trois, on pourrait en avoir beaucoup plus, ce nombre dépendant de la largeur de la tâche laser qui peut aller de 2 à 5 cm voire plus.

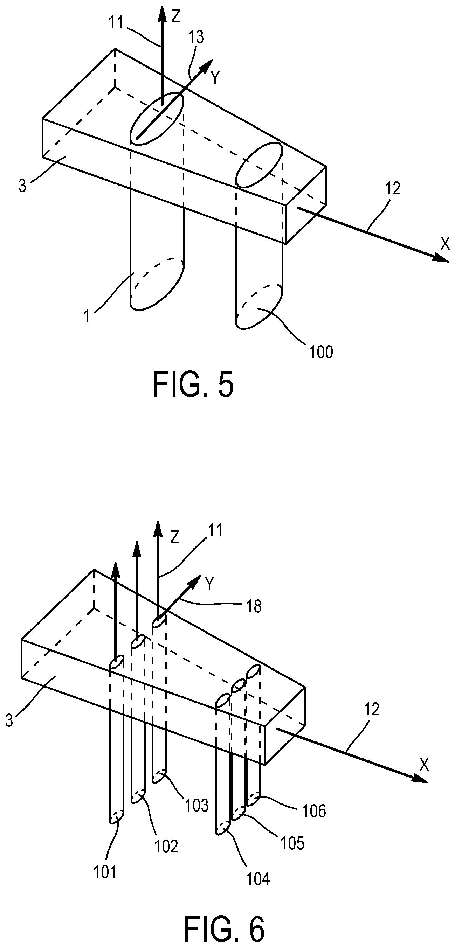

Dans une troisième variante du premier mode de réalisation de dispositif 9 qui peut correspondre à la vue de coupe de profil de la figure 4 et de la vue en perspective de la figure 5, l'injecteur 5 d'au moins un flux de réaction est agencé pour introduire dans la chambre 8 plusieurs flux de réaction 1, 100, séparés les uns des autres par le flux de gaz de confinement 2 et comprenant chacun le premier élément chimique et se propageant chacun selon la direction de flux 11.

L'injecteur 5 de réactif est agencé pour introduire, dans la chambre 8 et en provenance de la source 4 de réactif, plusieurs flux de réaction 1, 100, chaque flux 1, 100 se propageant selon la direction de flux 11 dans une zone 6 de flux de réaction qui lui est propre. Ces flux 1, 100 sont espacés selon la direction de rayonnement 12.

Les pertes par absorption du faisceau 3 par le flux de réaction 1 sont compensées par la focalisation (ou « convergence ») du faisceau 3 de sorte que la densité de puissance incidente du faisceau 3 sur chaque flux 1 ou 100 est identique pour tous les flux 1, 100 comme décrit dans le document FR 2 877 591.

Cette variante permet d'accroitre le taux de production. On peut avoir deux flux 1, 100 l'un à la suite de l'autre comme illustré sur la figure 5, ou en avoir 3, 4 ou encore plus ainsi les uns à la suite des autres, disposés d'affilée avec un seul faisceau laser 3.

Dans une quatrième variante du premier mode de réalisation de dispositif 9 qui peut correspondre à la vue de coupe de profil de la figure 4 et de la vue en perspective de la figure 6, l'injecteur 5 d'au moins un flux de réaction est agencé pour introduire dans la chambre 8 et en provenance de la source 4 de réactif plusieurs alignements de flux de réaction séparés les uns des autres par le flux de gaz de confinement 2 et comprenant chacun le premier élément chimique et se propageant chacun selon la direction de flux 11.

Sur la figure 6, on voit un premier alignement de flux 101, 102, 103 et un deuxième alignement de flux 104, 105, 106

Chaque flux 101, 102, 103, 104, 105 ou 106 se propage selon la direction de flux 11 dans une zone 6 de flux de réaction qui lui est propre.

L'injecteur 5 d'au moins un flux de réaction est agencé pour que les flux respectivement 101, 102, 103 ou 104, 104 et 105 (ou plus précisément leur section dans un plan perpendiculaire à la direction de flux 11) au sein de chaque alignement soient alignés le long d'une direction d'alignement 18 perpendiculaire à la direction de flux 11 et à la direction de rayonnement 12.

Les alignements de flux sont espacés entre eux selon la direction de rayonnement 12.

Les différents alignements de flux sont parallèles entre eux selon la même direction 18.

L'injecteur 5 se subdivise en plusieurs buses d'injection (une buse par flux de réaction). Chaque buse a une section qui est typiquement un ovale de 3 mm de profondeur le long de la direction 12 et de 4 mm de large le long de la direction 13, 18.

Les pertes par absorption du faisceau 3 par le premier alignement de flux 101, 102, 103 sont compensées par la focalisation (ou « convergence ») du faisceau 3 de sorte que la densité de puissance incidente du faisceau 3 sur chaque alignement de flux 101, 102, 103 ou 104, 105, 106 est identique pour tous les flux 101, 102, 103, 104, 105 ou 106 selon le principe décrit dans le document FR 2 877 591.

En référence aux figures 1 à 6, dans le premier mode de réalisation de dispositif 9 (quelle que soit sa variante considérée parmi ses quatre variantes précédemment décrites), l'injecteur de deuxième élément chimique est agencé pour introduire le deuxième élément dans la chambre 8 avec le premier élément chimique dans chaque flux de réaction 1, 100, 101, 102, 103, 104, 105, 106 avant (par rapport à direction de flux 11) la zone d'interaction 14 de chaque flux de réaction.

L'injecteur de deuxième élément chimique comprend l'injecteur 5 de réactif. Plus exactement, l'injecteur de deuxième élément chimique et l'injecteur 5 de réactif sont confondus.

En référence aux figures 1 à 6, un deuxième mode de réalisation de dispositif 9 selon l'invention est strictement identique au premier mode de réalisation de dispositif 9 précédemment décrit (quelle que soit sa variante considérée parmi ses quatre variantes précédemment décrites), mis à part le fait que l'injecteur de deuxième élément chimique est agencé pour introduire le deuxième élément chimique dans la chambre 8 dans un flux de gaz 2 entourant chaque flux de réaction 1, 100, 101, 102, 103, 104, 105, 106.

Plus exactement, l'injecteur de deuxième élément chimique est agencé pour introduire le deuxième élément chimique dans la chambre 8 dans le flux de gaz de confinement 2 avant (par rapport à direction de flux 11) la zone d'interaction 14 de chaque flux de réaction.

L'injecteur de deuxième élément chimique comprend l'injecteur 21 de gaz de confinement. Plus exactement, l'injecteur de deuxième élément chimique et l'injecteur 21 de gaz de confinement sont confondus.

Ce deuxième mode de réalisation est de préférence mis en oeuvre au sein de la deuxième ou quatrième variante (comprenant un ou plusieurs alignement(s) de flux 101, 102, 103 et 104, 105, 106 des figures 3 et 6) car cela permet de maximiser l'aire d'interaction entre le gaz de confinement 2 comprenant le deuxième élément chimique et chaque flux de réaction comprenant le premier élément chimique.

En référence aux figures 2 à 8, un troisième mode de réalisation de dispositif 9 selon l'invention est strictement identique au premier mode de réalisation de dispositif 9 précédemment décrit (quelle que soit sa variante considérée parmi ses quatre variantes précédemment décrites), mis à part le fait que l'injecteur de deuxième élément chimique est agencé pour introduire le deuxième élément chimique dans la chambre 8 dans un flux de gaz 7 entourant chaque flux de réaction 1, 100, 101, 102, 103, 104, 105, 106.

L'injecteur de deuxième élément chimique comprend un injecteur 22 (de préférence de forme annulaire) :
- par flux de réaction 1, 100, 101, 102, 103, 104, 105, 106, ou
- commun entourant de manière globale tous les flux de réaction.

Pour chaque flux de réaction considéré 1, 100, 101, 102, 103, 104, 105, ou 106, l'injecteur de deuxième élément chimique est agencé pour introduire le deuxième élément chimique dans la chambre 8 dans un flux de gaz de périphérie 7 entourant ce flux de réaction 1, 100, 101, 102, 103, 104, 105, ou 106 et émis à partir de plusieurs points 17 répartis le long d'une courbe fermée (forme typiquement annulaire de l'injecteur 22) entourant ce flux de réaction et agencés pour diriger le flux de gaz de périphérie 7 en direction de ce flux de réaction.

Pour chaque flux de réaction considéré 1, 100, 101, 102, 103, 104, 105, ou 106, l'injecteur de deuxième élément chimique est agencé pour introduire le deuxième élément chimique dans la chambre 8 dans le flux de gaz de périphérie 7 après (par rapport à direction de flux 11) la zone d'interaction 14 de ce flux de réaction. Ceci est particulièrement intéressant, car cela permet d'avoir un bon contrôle (en jouant sur la puissance du faisceau 3) et une bonne homogénéité de fabrication des coeurs 15 de particules 10. La fabrication des couches 16 sur les coeurs 15 des particules ne vient pas prendre directement de l'énergie du faisceau 3 et ne perturbe donc pas la maîtrise que l'on a sur la fabrication des coeurs 15. En effet, la fabrication des couches 16 sur les coeurs 15 des particules utilise l'énergie de la flamme 26 après la zone d'interaction 14.

Ce troisième mode de réalisation de dispositif 9 comprend des moyens pour déplacer (non représentés, comprenant par exemple une platine de micro-déplacement) chaque injecteur 22 le long de la direction de flux 11 de manière à optimiser la couche 16 fabriquée pour les particules 10.

Bien entendu, les différentes variantes et les différents modes de réalisation du dispositif venant d'être décrits peuvent être combinés entre eux, et l'injecteur de deuxième élément chimique peut donc comprendre :
- l'injecteur 5 de flux de réaction, et/ou (de préférence et)
- au moins un (éventuellement les deux) parmi :
   ∘ l'injecteur 21 de gaz de confinement, et/ou
   ∘ un injecteur 22 de gaz de périphérie 7 par flux de réaction ou un injecteur commun 22 de gaz de périphérie 7 entourant de manière globale tous les flux de réaction.

On va maintenant décrire un procédé mis en oeuvre dans l'un quelconque des modes de réalisation de dispositif 9 venant d'être décrit.

Ce procédé pour produire par pyrolyse laser des particules 10, comprend les étapes suivantes :
- introduire dans la chambre de réaction 8, par l'injecteur 5 et en provenance de la source 4, au moins un flux de réaction 1, 100, 101, 102, 103, 104, 105, 106 comprenant le premier élément chimique et se propageant selon la direction de flux 11 ; chaque flux de réaction comprend lors de son introduction du réactif ; le débit typique de réactif introduit dans la chambre 8 est d'environ 20 litres par minutes.
- introduire dans la chambre de réaction 8, avant (par rapport à direction de flux 11) la zone d'interaction 14 de chaque flux de réaction, le flux de gaz de confinement 2 entourant chaque flux de réaction 1, 100, 101, 102, 103, 104, 105, 106 et se propageant selon la direction de flux 11; le débit typique de gaz de confinement introduit dans la chambre 8 est d'environ 50 litres par minutes.
- projeter, par l'émetteur 19, le faisceau de rayonnement 3 à travers la chambre de réaction 8 en intersection, dans une zone d'interaction 14 par flux de réaction, avec chaque flux de réaction 1, 100, 101, 102, 103, 104, 105, 106 pour former dans chaque flux de réaction des coeurs de particules 15 comprenant le premier élément chimique, et
- introduire, dans la chambre de réaction 8, le deuxième élément chimique interagissant avec chaque flux de réaction 1, 101, 102, 103, 104, 105, 106 pour recouvrir les coeurs de particules 15 d'une couche 16 (propre à chaque particule 10 et indépendante de la couche 16 des autres particules 10) comprenant le deuxième élément chimique.

Comme vu précédemment, le réactif des flux de réaction est dénué d'agent oxydant le premier élément chimique. Ainsi, les coeurs 15 de particules obtenus par le procédé selon l'invention comprennent le premier élément chimique sous forme non oxydée.

Le nombre d'atomes introduits par unité de temps (typiquement par minute) du deuxième élément par rapport au nombre d'atomes introduits du premier élément est un rapport de un atome du deuxième élément introduit par unité de temps (dans la somme des flux de réaction 1, 100, 101, 102, 103, 104, 105, 106, de confinement 2 et éventuellement s'ils existent des flux de périphérie 7) pour au moins deux (de préférence au moins 3, de manière optimale au moins 5) atomes du premier élément par unité de temps (dans le flux 1).

Le nombre d'atomes introduits par unité de temps (typiquement par minute) du deuxième élément par rapport au nombre d'atomes introduits du premier élément est un rapport de un atome du deuxième élément introduit par unité de temps (dans la somme des flux de réaction 1, 100, 101, 102, 103, 104, 105, 106, de confinement 2 et éventuellement s'ils existent des flux de périphérie 7) pour deux (de préférence trois, de manière optimale cinq) à cinquante atomes du premier élément par unité de temps.

Le faisceau de rayonnement 3 se propage le long de la direction de rayonnement 12 perpendiculaire à la direction de flux 11.

Chaque flux de réaction possède, dans un plan perpendiculaire à la direction de flux 11, une section s'étendant longitudinalement le long de la direction d'élongation 13 perpendiculaire à la direction de flux 11 et à la direction de rayonnement 12.

Les particules 10 ainsi fabriquées tombent dans un récupérateur 27 où elles sont refroidies avant d'être acheminées par gravité et/ou aspiration vers une installation exploitant les particules ou vers un conteneur pour stockage.

Dans le procédé mis en oeuvre dans le premier mode de réalisation de dispositif, le deuxième élément chimique est introduit dans la chambre 8 avec le premier élément chimique dans le réactif dans chaque flux de réaction 1, 100, 101, 102, 103, 104, 105, 106 avant (par rapport à direction de flux 11) la zone d'interaction 14 de chaque flux de réaction.

Dans le procédé selon l'invention mis en oeuvre dans le deuxième ou troisième mode de réalisation de dispositif selon l'invention, le deuxième élément chimique est introduit dans la chambre 8 dans un flux de gaz 2 ou 7 entourant chaque flux de réaction 1, 100, 101, 102, 103, 104, 105, 106 et en contact avec chaque flux de réaction 1, 100, 101, 102, 103, 104, 105, 106.

Dans le procédé selon l'invention mis en oeuvre dans le deuxième mode de réalisation de dispositif selon l'invention, le deuxième élément chimique est introduit dans la chambre 8 dans le flux de gaz de confinement 2 avant (par rapport à direction de flux 11) la zone d'interaction 14 de chaque flux de réaction.

Ce mode de réalisation est particulièrement intéressant lorsque, comme précédemment décrit en référence à la figure 3 ou 6, l'introduction d'au moins un flux de réaction comprend une introduction de plusieurs flux de réaction alignés (alignement 101, 102, 103 et éventuellement en plus alignement 104, 105, 106) séparés les uns des autres par le flux de gaz de confinement 2 et comprenant chacun le premier élément chimique et se propageant chacun selon la direction de flux 11. On remarque que dans ce cas-là comme illustré sur la figure 3 le flux de gaz de confinement 2 est de préférence commun à tous les flux de réaction et sans discontinuité entre les différents flux de réaction. En outre, le faisceau de rayonnement 3 se propage le long de la direction de rayonnement 12 perpendiculaire à la direction de flux 11, et les différents flux de réaction 101, 102, 103 ou 104, 105, 106 au sein d'un alignement sont alignés le long de la direction d'alignement 18 perpendiculaire à la direction de flux 11 et à la direction de rayonnement 12.

Dans le procédé selon l'invention mis en oeuvre dans le troisième mode de réalisation de dispositif selon l'invention, le deuxième élément chimique est introduit dans la chambre 8 dans un flux de gaz de périphérie 7 entourant chaque flux de réaction 1, 100, 101, 102, 103, 104, 105, 106, émis à partir de plusieurs points 17 répartis le long d'une courbe fermée entourant chaque flux de réaction et se propageant en direction des flux de réaction. Le deuxième élément chimique est introduit dans la chambre 8 dans le flux de gaz de périphérie 7 après (par rapport à direction de flux 11) la zone d'interaction 14 de chaque flux de réaction.

Bien entendu, on peut imaginer différentes combinaisons de procédés précédemment décrits, dans lesquelles le deuxième élément chimique est introduit dans la chambre 8 :
- avec le premier élément chimique dans chaque flux de réaction 1, 100, 101, 102, 103, 104, 105, 106, et/ou (de préférence et)
- dans un flux de gaz 2 ou 7 entourant chaque flux de réaction 1, 100, 101, 102, 103, 104, 105, 106 et en contact avec chaque flux de réaction 1, 100, 101, 102, 103, 104, 105, 106, notamment :
   ∘ dans le flux de gaz de confinement 2, et/ou
   ∘ dans un flux de gaz de périphérie 7 par flux de réaction ou dans un flux de gaz de périphérie 7 commun entourant de manière globale tous les flux de réaction.

### EXEMPLE 1

Dans cet exemple, le premier élément chimique est du silicium.

Le premier élément chimique est introduit à température ambiante (approximativement 20°C) dans la chambre 8 sous la forme de SiH₄ gazeux, à approximativement 20 litres par minutes.

Le réactif de chaque flux de réaction est ainsi du silane (SiH₄) gazeux non mélangé à des agents oxydants ou à des atomes d'oxygène ou à des molécules comprenant des atomes d'oxygène, mais éventuellement mélangé avec une source (C₂H₂ ou C₂H₄ ou CH₄, de préférence C₂H₂) de deuxième élément chimique.

Les coeurs 15 de particules 10 ainsi obtenus sont en silicium non oxydé.

Le gaz de confinement 2 comprend de l'argon gazeux introduit dans la chambre 8 à température ambiante à 50 litres par minutes, éventuellement mélangé avec une source (C₂H₂ ou C₂H₄ ou CH₄, de préférence C₂H₂) de deuxième élément chimique.

Le deuxième élément est du carbone.

Le deuxième élément est introduit à température ambiante dans la chambre sous la forme d'acétylène (C₂H₂) gazeux à très approximativement 2 litres par minutes, éventuellement pour de meilleurs résultats réparti simultanément dans les flux de réaction (1, 100, 101, 102, 103, 104, 105, 106) et de confinement 2, ou de réaction (1, 100, 101, 102, 103, 104, 105, 106) et de périphérie 7 (par exemple à au moins 60% dans les flux 2 et/ou 7 entourant les flux de réaction et le reste dans les flux de réaction).

Le nombre d'atomes introduits de carbone (qui joue ici le rôle du deuxième élément) par rapport au nombre d'atomes introduits du premier élément (Silicium) est un rapport de un atome de carbone pour 5 atomes de silicium (1 mole de C₂H₂ pour 10 moles de SiH₄).

La couche 16 de chaque particule ainsi obtenue est en carbone.

### PARTICULES OBTENUES

Des particules selon le premier exemple ont été fabriquées avec le premier, deuxième et troisième mode de réalisation de dispositif 9 seuls ou en combinaison.

La taille des particules 10 obtenues correspond à un diamètre de coeur compris entre 10 et 500 nm (avec un écart type entre 2 et 60 nm), et une épaisseur de couche 16 entre 1 et 5 nm. Les particules ne sont pas nécessairement parfaitement sphériques. Par diamètre de coeur, on entend la distance reliant les deux points les plus distants du coeur (par exemple la longueur dans le cas d'un coeur en forme de bâtonnet).

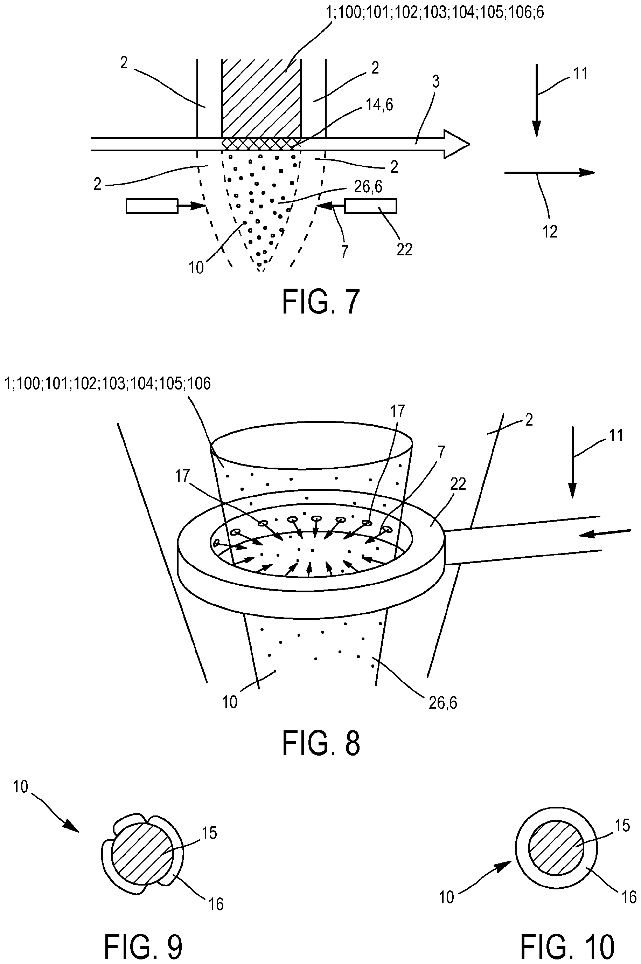

En utilisant le premier mode de réalisation de dispositif, pour lequel le deuxième élément chimique est introduit dans la chambre 8 avec le premier élément chimique dans chaque flux de réaction 1, 100, 101, 102, 103, 104, 105, 106, on remarque que la couche 16 n'est pas parfaitement uniforme, comme illustré sur la figure 9.

Cela peut être dû au fait que chaque flux de réaction est dénué d'agent oxydant le premier élément chimique. Le fait de ne pas utiliser d'agent oxydant est contre-intuitif, notamment dans le cas d'une couche 16 de carbone car les oxydants sont connus pour déshydrogéner les molécules telles que C₂H₄, C₆H₆,... et donc aider à former du carbone solide.

On note de meilleurs résultats du deuxième ou troisième mode de réalisation seul que du premier mode de réalisation seul.

L'homogénéité de la couche 16 peut être nettement améliorée en utilisant le deuxième et/ou troisième mode de réalisation de dispositif selon l'invention, dans lequel le deuxième élément chimique est introduit dans la chambre 8 dans un flux de gaz 2 ou 7 entourant chaque flux de réaction 1, 100, 101, 102, 103, 104, 105, 106 et en contact avec chaque flux de réaction 1, 100, 101, 102, 103, 104, 105, 106, plus particulièrement avec le deuxième mode de réalisation de dispositif selon l'invention pour lequel le deuxième élément chimique est introduit dans la chambre 8 dans le flux de gaz de confinement 2. La couche 16 est alors bien plus homogène, comme illustré sur la figure 10.

On note encore de meilleurs résultats du deuxième et/ou troisième mode de réalisation combiné(s) au premier mode de réalisation que du deuxième ou troisième mode de réalisation seul.

On remarque que dans les exemples et modes de réalisation précédemment décrits le coeur 15 ne comprend pas le deuxième élément chimique (sous une forme quelconque).

On remarque que dans les exemples et modes de réalisation précédemment décrits la couche 16 ne comprend pas le premier élément chimique (sous une forme quelconque).

On remarque que dans les exemples et modes de réalisation précédemment décrits le coeur 15 ne comprend de préférence pas le premier élément chimique sous forme oxydée, mais comprend de préférence ce premier élément chimique uniquement sous forme non-oxydée.

On remarque que dans les exemples et modes de réalisation précédemment décrits il n'y a pas d'interface entre le coeur 15 et la couche 16 de chaque particule décrite. Cependant, on remarque que de manière générale l'invention n'est pas incompatible avec l'existence d'une interface entre le coeur 15 et la couche 16 d'une même particule.

Bien sûr, l'invention n'est pas limitée aux exemples, modes de réalisation et variantes qui viennent d'être décrits et de nombreux aménagements peuvent être apportés à ces exemples sans sortir du cadre de l'invention.

Bien entendu, les différentes caractéristiques, formes, variantes et modes de réalisation de l'invention peuvent être associées les unes avec les autres selon diverses combinaisons dans la mesure où elles ne sont pas incompatibles ou exclusives les unes des autres. En particulier toutes les variantes et modes de réalisation décrits précédemment sont combinables entre eux.

## Revendications

1. Procédé pour produire des particules (10), comprenant les étapes suivantes :
- Introduire dans une chambre de réaction (8) au moins un flux de réaction (1, 100, 101, 102, 103, 104, 105, 106) comprenant comme premier élément chimique du Silicium et se propageant selon une direction de flux (11),
- Projeter un faisceau de rayonnement (3) à travers la chambre de réaction (8) en intersection avec chaque flux de réaction (1, 100, 101, 102, 103, 104, 105, 106) dans une zone d'interaction (14) par flux de réaction, pour former dans chaque flux de réaction des coeurs de particules (15) comprenant le premier élément chimique, et
- Introduire, dans la chambre de réaction (8), un deuxième élément chimique interagissant avec chaque flux de réaction (1, 100, 101, 102, 103, 104, 105, 106) pour recouvrir les coeurs de particules (15) d'une couche (16) comprenant le deuxième élément chimique,
chaque flux de réaction (1, 100, 101, 102, 103, 104, 105, 106) étant dénué d'agent oxydant le premier élément chimique, et les coeurs (15) de particules comprenant le premier élément chimique sous forme non oxydée, le nombre d'atomes introduits du deuxième élément par rapport au nombre d'atomes introduits du premier élément correspondant à un rapport de un atome du deuxième élément introduit par unité de temps pour au moins deux atomes du premier élément introduit par unité de temps, le deuxième élément chimique étant introduit dans la chambre (8) dans un flux de gaz (2 ;7) entourant chaque flux de réaction (1, 100, 101, 102, 103, 104, 105, 106), **caractérisé en ce que** :
- le deuxième élément chimique est introduit dans la chambre (8) dans un flux de gaz de périphérie (7) entourant chaque flux de réaction (1, 100, 101, 102, 103, 104, 105, 106), émis à partir de plusieurs points (17) répartis le long d'une courbe fermée entourant chaque flux de réaction (1, 100, 101, 102, 103, 104, 105, 106) et se propageant en direction de chaque flux de réaction, le deuxième élément chimique étant introduit dans la chambre (8) dans le flux de gaz de périphérie (7) après la zone d'interaction (14) de chaque flux de réaction, et/ou
- il comprend en outre comme étape introduire dans la chambre de réaction (8), avant la zone d'interaction (14) de chaque flux de réaction, un flux de gaz de confinement (2) entourant chaque flux de réaction (1, 100, 101, 102, 103, 104, 105, 106) et se propageant selon la direction de flux (11), le deuxième élément chimique étant introduit dans la chambre (8) dans le flux de gaz de confinement (2) avant la zone d'interaction (14) de chaque flux de réaction.

2. Procédé selon la revendication 1, **caractérisé en ce que** le deuxième élément chimique est introduit dans la chambre (8) dans le flux de gaz de périphérie (7) entourant chaque flux de réaction (1, 100, 101, 102, 103, 104, 105, 106), émis à partir de plusieurs points (17) répartis le long de la courbe fermée entourant chaque flux de réaction (1, 100, 101, 102, 103, 104, 105, 106) et se propageant en direction de chaque flux de réaction, le deuxième élément chimique étant introduit dans la chambre (8) dans le flux de gaz de périphérie (7) après la zone d'interaction (14) de chaque flux de réaction.

3. Procédé selon la revendications 1 ou 2, **caractérisé en ce qu'**il comprend l'étape d'introduire dans la chambre de réaction (8), avant la zone d'interaction (14) de chaque flux de réaction, le flux de gaz de confinement (2) entourant chaque flux de réaction (1, 100, 101, 102, 103, 104, 105, 106) et se propageant selon la direction de flux (11), le deuxième élément chimique étant introduit dans la chambre (8) dans le flux de gaz de confinement (2) avant la zone d'interaction (14) de chaque flux de réaction.

4. Procédé selon la revendication 3, **caractérisé en ce que** l'introduction d'au moins un flux de réaction comprend une introduction d'au moins un alignement de plusieurs flux de réaction (101, 102, 103 ; 104, 105, 106) séparés les uns des autres par le flux de gaz de confinement (2) et comprenant chacun le premier élément chimique et se propageant chacun selon la direction de flux (11).

5. Procédé selon la revendication 4, **caractérisé en ce que** le faisceau de rayonnement (3) se propage le long d'une direction de rayonnement (12) perpendiculaire à la direction de flux (11), et **en ce que** les flux de chaque alignement de flux de réaction (101, 102, 103 ; 104, 105, 106) sont alignés le long d'une direction d'alignement (18) perpendiculaire à la direction de flux (11) et à la direction de rayonnement (12).

6. Procédé selon l'une quelconque des revendications 1 à 5, **caractérisé en ce que** le faisceau de rayonnement (3) se propage le long d'une direction de rayonnement (12) perpendiculaire à la direction de flux (11), et **en ce que** chaque flux de réaction (1, 100, 101, 102, 103, 104, 105, 106) possède, dans un plan perpendiculaire à la direction de flux (11), une section s'étendant longitudinalement le long d'une direction d'élongation (13) perpendiculaire à la direction de flux (11) et à la direction de rayonnement (12).

7. Procédé selon l'une quelconque des revendications précédentes, **caractérisé en ce que** le deuxième élément chimique est introduit dans la chambre (8) avec le premier élément chimique dans chaque flux de réaction (1, 100, 101, 102, 103, 104, 105, 106) avant la zone d'interaction (14) de chaque flux de réaction.

8. Procédé selon l'une quelconque des revendications précédentes, **caractérisé en ce que** le premier élément chimique est introduit dans la chambre (8) sous la forme de SiH₄.

9. Procédé selon l'une quelconque des revendications précédentes, **caractérisé en ce que** les coeurs (15) de particules (10) sont en silicium.

10. Procédé selon l'une quelconque des revendications précédentes, **caractérisé en ce que** le deuxième élément est du carbone.

11. Particules comprenant chacune:
- un coeur (15) comprenant comme premier élément chimique du silicium non oxydé, ayant un diamètre compris entre 3 et 900 nm, et
- une couche (16) entourant le coeur, consistant uniquement en un deuxième élément chimique de carbone et ayant une épaisseur de couche d'au minimum 0.5 nm.

12. Dispositif (9) pour produire des particules (10), comprenant:
- une source de réactif comprenant du réactif, ce réactif comprenant comme premier élément chimique du silicium;
- une chambre de réaction (8) reliée à la source de réactif ;
- un injecteur de réactif agencé pour introduire, dans la chambre (8) et en provenance de la source de réactif, au moins un flux de réaction (1, 100, 101, 102, 103, 104, 105, 106) comprenant ledit réactif et se propageant selon une direction de flux (11) dans une zone (6) de flux de réaction par flux de réaction,
- un émetteur d'un faisceau de rayonnement agencé pour projeter le faisceau de rayonnement (3) à travers la chambre de réaction (8) en intersection avec chaque zone (6) de flux de réaction (1, 100, 101, 102, 103, 104, 105, 106) dans une zone d'interaction (14) par flux de réaction,
- une source d'un deuxième élément chimique, et
- un injecteur de deuxième élément agencé pour introduire, dans la chambre de réaction (8), le deuxième élément chimique à partir de la source de deuxième élément de sorte que ce deuxième élément chimique soit apte à interagir dans le chambre (8) avec chaque flux de réaction (1, 100, 101, 102, 103, 104, 105, 106),
le réactif (1; 101, 102, 103) étant dénué d'agent oxydant le premier élément chimique, l'injecteur de deuxième élément et l'injecteur de premier élément étant agencés ensemble pour introduire un nombre d'atomes du deuxième élément par rapport à un nombre d'atomes du premier élément selon un rapport de un atome du deuxième élément pour au moins deux atomes du premier élément, l'injecteur de deuxième élément chimique étant agencé pour introduire le deuxième élément chimique dans la chambre (8) dans un flux de gaz (2 ;7) entourant chaque flux de réaction (1, 100, 101, 102, 103, 104, 105, 106), **caractérisé en ce que** :
- l'injecteur de deuxième élément chimique est agencé pour introduire le deuxième élément chimique dans la chambre (8) dans un flux de gaz de périphérie (7) entourant chaque flux de réaction (1, 100, 101, 102, 103, 104, 105, 106), émis à partir de plusieurs points (17) répartis le long d'une courbe fermée entourant chaque flux de réaction et agencés pour diriger le flux de gaz de périphérie en direction de chaque flux de réaction, l'injecteur de deuxième élément chimique étant agencé pour introduire le deuxième élément chimique dans la chambre (8) dans le flux de gaz de périphérie (7) après la zone d'interaction (14) de chaque flux de réaction, et/ou
- il comprend en outre un injecteur de gaz de confinement agencé pour introduire dans la chambre de réaction (8), avant la zone d'interaction (14) de chaque flux de réaction, un flux de gaz de confinement (2) entourant chaque flux de réaction (1, 100, 101, 102, 103, 104, 105, 106) et se propageant selon la direction de flux (11), et **en ce que** l'injecteur de deuxième élément chimique comprend l'injecteur de gaz de confinement.

13. Dispositif selon la revendication 12, **caractérisé en ce que** l'injecteur de deuxième élément chimique est agencé pour introduire le deuxième élément chimique dans la chambre (8) dans le flux de gaz de périphérie (7) entourant chaque flux de réaction (1, 100, 101, 102, 103, 104, 105, 106), émis à partir de plusieurs points (17) répartis le long de la courbe fermée entourant chaque flux de réaction et agencés pour diriger le flux de gaz de périphérie en direction de chaque flux de réaction, l'injecteur de deuxième élément chimique étant agencé pour introduire le deuxième élément chimique dans la chambre (8) dans le flux de gaz de périphérie (7) après la zone d'interaction (14) de chaque flux de réaction.

14. Dispositif selon la revendication 12 ou 13, **caractérisé en ce qu'**il comprend l'injecteur de gaz de confinement agencé pour introduire dans la chambre de réaction (8), avant la zone d'interaction (14) de chaque flux de réaction, le flux de gaz de confinement (2) entourant chaque flux de réaction (1, 100, 101, 102, 103, 104, 105, 106) et se propageant selon la direction de flux (11), et **en ce que** l'injecteur de deuxième élément chimique comprend l'injecteur de gaz de confinement.

15. Dispositif selon la revendication 14, **caractérisé en ce que** l'injecteur d'au moins un flux de réaction est agencé pour introduire dans la chambre au moins un alignement de plusieurs flux de réaction (101, 102, 103; 104, 105, 106) séparés les uns des autres par le flux de gaz de confinement (2) et comprenant chacun le premier élément chimique et se propageant chacun selon la direction de flux (11).

16. Dispositif selon la revendication 15, **caractérisé en ce que** l'émetteur est agencé pour que le faisceau de rayonnement (3) se propage le long d'une direction de rayonnement (12) perpendiculaire à la direction de flux (11), et **en ce que** l'injecteur d'au moins un flux de réaction est agencé pour que les flux de chaque alignement de flux de réaction (101, 102, 103 ; 104, 105, 106) soient alignés le long d'une direction d'alignement (18) perpendiculaire à la direction de flux (11) et à la direction de rayonnement (12).

17. Dispositif selon l'une quelconque des revendications 12 à 16, **caractérisé en ce que** l'émetteur est agencé pour que le faisceau de rayonnement (3) se propage le long d'une direction de rayonnement (12) perpendiculaire à la direction de flux (11), et **en ce que** l'injecteur d'au moins un flux de réaction est agencé pour que chaque flux de réaction (1, 100, 101, 102, 103, 104, 105, 106) possède, dans un plan perpendiculaire à la direction de flux (11), une section s'étendant longitudinalement le long d'une direction d'élongation (13) perpendiculaire à la direction de flux (11) et à la direction de rayonnement (12).

18. Dispositif selon l'une quelconque des revendications 12 à 17, **caractérisé en ce que** l'injecteur de deuxième élément chimique est agencé pour introduire le deuxième élément dans la chambre (8) avec le premier élément chimique dans chaque flux de réaction (1, 100, 101, 102, 103, 104, 105, 106) avant la zone d'interaction (14) de chaque flux de réaction.

## Patentansprüche

1. Verfahren zum Herstellen von Partikeln (10), umfassend die nachstehenden Schritte:
- Einleiten von zumindest einem Reaktionsfluss (1, 100, 101, 102, 103, 104, 105, 106) in eine Reaktionskammer (8), der als erstes chemisches Element Silicium enthält und sich in einer Fließrichtung (11) ausbreitet,
- Projizieren eines Strahlenbündels (3) durch die Reaktionskammer (8) in Überschneidung mit jedem Reaktionsfluss (1, 100, 101, 102, 103, 104, 105, 106) in einem Wechselwirkungsbereich (14) pro Reaktionsfluss, um in jedem Reaktionsfluss das erste chemische Element enthaltende Partikelkerne (15) zu bilden, und
- Einleiten eines zweiten chemischen Elements in die Reaktionskammer (8), das mit jedem Rektionsfluss (1, 100, 101, 102, 103, 104, 105, 106) in Wechselwirkung tritt, um die Partikelkerne (15) mit einer Schicht (16) zu überziehen, die das zweite chemische Element enthält,
wobei jeder Reaktionsfluss (1, 100, 101, 102, 103, 104, 105, 106) frei von das erste chemische Element oxidierendem Oxidationsmittel ist und wobei die Partikelkerne (15) das erste chemische Element in nicht oxidierter Form enthalten, wobei die Anzahl an eingeleiteten Atomen des zweiten Elements gegenüber der Anzahl an eingeleiteten Atomen des ersten Elements einem Verhältnis von einem Atom des pro Zeiteinheit eingeleiteten zweiten Elements zu zumindest zwei Atomen des pro Zeiteinheit eingeleiteten ersten Elements entspricht, wobei das zweite chemische Element in die Kammer (8) in einem Gasfluss (2; 7) eingeleitet wird, der jeden Reaktionsfluss (1, 100, 101, 102, 103, 104, 105, 106) umgibt, **dadurch gekennzeichnet, dass**:
- das zweite chemische Element in die Kammer (8) in einem Umfangsgasfluss (7) eingeleitet wird, der jeden Reaktionsfluss (1, 100, 101, 102, 103, 104, 105, 106) umgibt, von mehreren Stellen (17) aus abgegeben wird, die entlang einer jeden Reaktionsfluss (1, 100, 101, 102, 103, 104, 105, 106) umgebenden geschlossenen Kurve verteilt sind, und der sich in Richtung eines jeden Reaktionsflusses ausbreitet, wobei das zweite chemische Element nach dem Wechselwirkungsbereich (14) eines jeden Reaktionsflusses im Umfangsgasfluss (7) in die Kammer (8) eingeleitet wird, und/oder
- es ferner als Schritt das Einleiten eines Sicherheitsgasflusses (2) vor dem Wechselwirkungsbereich (14) eines jeden Reaktionsflusses in die Reaktionskammer (8) umfasst, der jeden Reaktionsfluss (1, 100, 101, 102, 103, 104, 105, 106) umgibt und sich in Fließrichtung (11) ausbreitet, wobei das zweite chemische Element vor dem Wechselwirkungsbereich (14) eines jeden Reaktionsflusses im Sicherheitsgasfluss (2) in die Kammer (8) eingeleitet wird.

2. Verfahren nach Anspruch 1, **dadurch gekennzeichnet, dass** das zweite chemische Element im Umfangsgasfluss (7) in die Kammer (8) eingeleitet wird, der jeden Reaktionsfluss (1, 100, 101, 102, 103, 104, 105, 106) umgibt, von mehreren Stellen (17) aus abgegeben wird, die entlang der jeden Reaktionsfluss (1, 100, 101, 102, 103, 104, 105, 106) umgebenden geschlossenen Kurve verteilt sind, und der sich in Richtung eines jeden Reaktionsflusses ausbreitet, wobei das zweite chemische Element nach dem Wechselwirkungsbereich (14) eines jeden Reaktionsflusses im Umfangsgasfluss (7) in die Kammer (8) eingeleitet wird.

3. Verfahren nach Anspruch 1 oder 2, **dadurch gekennzeichnet, dass** es den Schritt des Einleitens des Sicherheitsgasflusses (2) vor dem Wechselwirkungsbereich (14) eines jeden Reaktionsflusses in die Reaktionskammer (8) umfasst, der jeden Reaktionsfluss (1, 100, 101, 102, 103, 104, 105, 106) umgibt und sich in Fließrichtung (11) ausbreitet, wobei das zweite chemische Element vor dem Wechselwirkungsbereich (14) eines jeden Reaktionsflusses im Sicherheitsgasfluss (2) in die Kammer (8) eingeleitet wird.

4. Verfahren nach Anspruch 3, **dadurch gekennzeichnet, dass** das Einleiten zumindest eines Reaktionsflusses ein Einleiten zumindest einer Reihe von mehreren Reaktionsflüssen (101, 102, 103 ; 104, 105, 106) umfasst, die durch den Sicherheitsgasfluss (2) voneinander getrennt sind und jeweils das erste chemische Element enthalten und sich jeweils in Fließrichtung (11) ausbreiten.

5. Verfahren nach Anspruch 4, **dadurch gekennzeichnet, dass** das Strahlungsbündel (3) sich in einer Strahlungsrichtung (12) ausbreitet, die senkrecht zur Fließrichtung (11) verläuft, und dass die Flüsse einer jeden Reihe von Reaktionsflüssen (101, 102, 103 ; 104, 105, 106) in einer Aneinanderreihungsrichtung (18) ausgerichtet sind, die senkrecht zur Fließrichtung (11) und zur Strahlungsrichtung (12) verläuft.

6. Verfahren nach einem der Ansprüche 1 bis 5, **dadurch gekennzeichnet, dass** das Strahlungsbündel (3) sich in einer Strahlungsrichtung (12) ausbreitet, die senkrecht zur Fließrichtung (11) verläuft, und dass jeder Reaktionsfluss (1, 100, 101, 102, 103, 104, 105, 106) in einer senkrecht zur Fließrichtung (11) verlaufenden Ebene einen Querschnitt besitzt, der sich längs einer Erstreckungsrichtung (13) erstreckt, die senkrecht zur Fließrichtung (11) und zur Strahlungsrichtung (12) verläuft.

7. Verfahren nach einem der vorangehenden Ansprüche, **dadurch gekennzeichnet, dass** das zweite chemische Element vor dem Wechselwirkungsbereich (14) eines jeden Reaktionsflusses mit dem ersten chemischen Element in jedem Reaktionsfluss (1, 100, 101, 102, 103, 104, 105, 106) in die Kammer (8) eingeleitet wird.

8. Verfahren nach einem der vorangehenden Ansprüche, **dadurch gekennzeichnet, dass** das erste chemische Element in Form von SiH₄ in die Kammer (8) eingeleitet wird.

9. Verfahren nach einem der vorangehenden Ansprüche, **dadurch gekennzeichnet, dass** die Kerne (15) der Partikel (10) aus Silicium bestehen.

10. Verfahren nach einem der vorangehenden Ansprüche, **dadurch gekennzeichnet, dass** das zweite Element Kohlenstoff ist.

11. Partikel, jeweils enthaltend:
- einen Kern (15), der als erstes chemisches Element nicht oxidiertes Silicium mit einem Durchmesser zwischen 3 und 900 nm enthält, und
- eine den Kern umgebende Schicht (16), die nur aus einem zweiten chemischen Element aus Kohlenstoff besteht und eine Schichtdicke von zumindest 0,5 nm hat.

12. Vorrichtung (9) zum Herstellen von Partikeln (10), enthaltend:
- eine Reagensquelle mit Reagens, wobei das Reagens als erstes chemisches Element Silicium enthält;
- eine Reaktionskammer (8), die mit der Reagensquelle verbunden ist,
- einen Reagensinjektor, der dazu ausgebildet ist, zumindest einen Reaktionsfluss (1, 100, 101, 102, 103, 104, 105, 106) von der Reagensquelle kommend in die Kammer (8) einzuleiten, der das Reagens enthält und sich in einer Fließrichtung (11) in einem Reaktionsflussbereich (6) pro Reaktionsfluss ausbreitet,
- einen Strahler für ein Strahlungsbündel, der dazu ausgebildet ist, das Strahlungsbündel (3) durch die Reaktionskammer (8) in Überschneidung mit jedem Bereich (6) des Reaktionsflusses (1, 100, 101, 102, 103, 104, 105, 106) in einem Wechselwirkungsbereich (14) pro Reaktionsfluss zu projizieren,
- eine Quelle für ein zweites chemisches Element, und
- einen Injektor für das zweite Element, der dazu ausgebildet ist, das zweite chemische Element ausgehend von der Quelle des zweiten Elements in die Reaktionskammer (8) einzuleiten, so dass dieses zweite chemische Element in der Lage ist, in der Kammer (8) mit jedem Reaktionsfluss (1, 100, 101, 102, 103, 104, 105, 106) in Wechselwirkung zu treten,
wobei das Reagens (1; 101, 102, 103) frei von das erste chemische Element oxidierendem Oxidationsmittel ist, wobei der Injektor für das zweite Element und der Injektor für das erste Element zusammen dazu ausgebildet sind, eine Anzahl an Atomen des zweiten Elements gegenüber einer Anzahl an Atomen des ersten Elements gemäß einem Verhältnis von einem Atom des zweiten Elements zu zumindest zwei Atomen des ersten Elements einzuleiten, wobei der Injektor des zweiten chemischen Elements dazu ausgebildet ist, das zweite chemische Element in die Kammer (8) in einem Gasfluss (2; 7) einzuleiten, der jeden Reaktionsfluss (1, 100, 101,102, 103, 104, 105, 106) umgibt, **dadurch gekennzeichnet, dass**:
- der Injektor für das zweite chemische Element dazu ausgebildet ist, das zweite chemische Element in die Kammer (8) in einem Umfangsgasfluss (7) einzuleiten, der jeden Reaktionsfluss (1, 100, 101, 102, 103, 104, 105, 106) umgibt, von mehreren Stellen (17) aus abgegeben wird, die entlang einer jeden Reaktionsfluss umgebenden geschlossenen Kurve verteilt sind, und der dazu ausgebildet ist, den Umfangsgasfluss in Richtung eines jeden Reaktionsflusses zu lenken, wobei der Injektor für das zweite chemische Element dazu ausgebildet ist, das zweite chemische Element nach dem Wechselwirkungsbereich (14) eines jeden Reaktionsflusses im Umfangsgasfluss (7) in die Kammer (8) einzuleiten, und/oder dass
- sie ferner einen Injektor für Sicherheitsgas enthält, der dazu ausgebildet ist, vor dem Wechselwirkungsbereich (14) eines jeden Reaktionsflusses einen Sicherheitsgasfluss (2) in die Kammer (8) einzuleiten, der jeden Reaktionsfluss (1, 100, 101, 102, 103, 104, 105, 106) umgibt und sich in Fließrichtung (11) ausbreitet, und dass der Injektor für das zweite chemische Element den Injektor für Sicherheitsgas enthält.

13. Vorrichtung nach Anspruch 12, **dadurch gekennzeichnet, dass** der Injektor für das zweite chemische Element dazu ausgebildet ist, das zweite chemische Element in die Kammer (8) im Umfangsgasfluss (7) einzuleiten, der jeden Reaktionsfluss (1, 100, 101, 102, 103, 104, 105, 106) umgibt, von mehreren Stellen (17) aus abgegeben wird, die entlang der jeden Reaktionsfluss umgebenden geschlossenen Kurve verteilt sind und dazu ausgebildet sind, den Umfangsgasfluss in Richtung eines jeden Reaktionsflusses zu lenken, wobei der Injektor für das zweite chemische Element dazu ausgebildet ist, das zweite chemische Element nach dem Wechselwirkungsbereich (14) eines jeden Reaktionsflusses im Umfangsgasfluss (7) in die Kammer (8) einzuleiten.

14. Vorrichtung nach Anspruch 12 oder 13, **dadurch gekennzeichnet, dass** sie den Injektor für Sicherheitsgas enthält, der dazu ausgebildet ist, vor dem Wechselwirkungsbereich (14) eines jeden Rektionsflusses den Sicherheitsgasfluss (2) in die Reaktionskammer (8) einzuleiten, der jeden Reaktionsfluss (1, 100, 101, 102, 103, 104, 105, 106) umgibt und sich in der Fließrichtung (11) ausbreitet, und dass der Injektor für das zweite chemische Element den Injektor für Sicherheitsgas umfasst.

15. Vorrichtung nach Anspruch 14, **dadurch gekennzeichnet, dass** der Injektor für zumindest einen Reaktionsfluss dazu ausgebildet ist, zumindest eine Reihe von mehreren Reaktionsflüssen (101, 102, 103; 104, 105, 106) in die Kammer einzuleiten, die durch den Sicherheitsgasfluss (2) voneinander getrennt sind und jeweils das erste chemische Element enthalten und sich jeweils in Fließrichtung (11) ausbreiten.

16. Vorrichtung nach Anspruch 15, **dadurch gekennzeichnet, dass** der Strahler dazu ausgebildet ist, dass das Strahlungsbündel (3) sich entlang einer Strahlungsrichtung (12) ausbreitet, die senkrecht zur Fließrichtung (11) verläuft, und dass der Injektor für zumindest einen Reaktionsfluss dazu ausgebildet ist, dass die Ströme einer jeden Reihe von Reaktionsflüssen (101, 102, 103; 104, 105, 106) entlang einer Aneinanderreihungsrichtung (18) ausgerichtet sind, die senkrecht zur Fließrichtung (11) und zur Strahlungsrichtung (12) verläuft.

17. Vorrichtung nach einem der Ansprüche 12 bis 16, **dadurch gekennzeichnet, dass** der Strahler dazu ausgebildet ist, dass das Strahlungsbündel (3) sich entlang einer Strahlungsrichtung (12) ausbreitet, die senkrecht zur Fließrichtung (11) verläuft, und dass der Injektor für zumindest einen Reaktionsfluss dazu ausgebildet ist, dass jeder Reaktionsfluss (1, 100, 101, 102, 103, 104, 105, 106) in einer senkrecht zur Fließrichtung (11) verlaufenden Ebene einen Querschnitt besitzt, der sich längs einer Erstreckungsrichtung (13) erstreckt, die senkrecht zur Fließrichtung (11) und zur Strahlungsrichtung (12) verläuft.

18. Vorrichtung nach einem der Ansprüche 12 bis 17, **dadurch gekennzeichnet, dass** der Injektor für das zweite chemische Element dazu ausgebildet ist, das zweite Element mit dem ersten chemischen Element in jedem Reaktionsfluss (1, 100, 101, 102, 103, 104, 105, 106) vor dem Wechselwirkungsbereich (14) eines jeden Reaktionsflusses in die Kammer (8) einzuleiten.

## Claims

1. Process for producing particles (10), comprising the following steps:
- introducing into a reaction chamber (8) at least one reaction flow (1, 100, 101, 102, 103, 104, 105, 106) comprising silicon as first chemical element and propagating along a flow direction (11),
- projecting a radiation beam (3) through the reaction chamber (8) intersecting each reaction flow (1, 100, 101, 102, 103, 104, 105, 106) in one interaction zone (14) per reaction flow, in order to form in each reaction flow, particle cores (15) comprising the first chemical element, and
- introducing, into the reaction chamber (8), a second chemical element interacting with each reaction flow (1, 100, 101, 102, 103, 104, 105, 106) in order to cover the particle cores (15) with a layer (16) comprising the second chemical element,
each reaction flow (1, 100, 101, 102, 103, 104, 105, 106) being devoid of agent oxidizing the first chemical element, and the cores (15) of particles comprising the first chemical element in non-oxidized form, the number of atoms of the second element introduced relative to the number of atoms of the first element introduced corresponding to a ratio of one atom of the second element introduced per unit of time to at least two atoms of the first element introduced per unit of time, the second chemical element being introduced into the chamber (8) in a gas flow (2; 7) surrounding each reaction flow (1, 100, 101, 102, 103, 104, 105, 106), **characterized in that**:
- the second chemical element is introduced into the chamber (8) in a peripheral gas flow (7) surrounding each reaction flow (1, 100, 101, 102, 103, 104, 105, 106), emitted from several points (17) distributed along a closed curve surrounding each reaction flow (1, 100, 101, 102, 103, 104, 105, 106) and propagating in the direction of each reaction flow, the second chemical element being introduced into the chamber (8) in the peripheral gas flow (7) after the interaction zone (14) of each reaction flow, and/or
- it further comprises a step of introducing into the reaction chamber (8), before the interaction zone (14) of each reaction flow, a confinement gas flow (2) surrounding each reaction flow (1, 100, 101, 102, 103, 104, 105, 106) and propagating along the flow direction (11), the second chemical element being introduced into the chamber (8) in the confinement gas flow (2) before the interaction zone (14) of each reaction flow.

2. Process according to Claim 1, **characterized in that** the second chemical element is introduced into the chamber (8) in the peripheral gas flow (7) surrounding each reaction flow (1, 100, 101, 102, 103, 104, 105, 106), emitted from several points (17) distributed along the closed curve surrounding each reaction flow (1, 100, 101, 102, 103, 104, 105, 106) and propagating in the direction of each reaction flow, the second chemical element being introduced into the chamber (8) in the peripheral gas flow (7) after the interaction zone (14) of each reaction flow.

3. Process according to Claim 1 or 2, **characterized in that** it comprises the step of introducing into the reaction chamber (8), before the interaction zone (14) of each reaction flow, the confinement gas flow (2) surrounding each reaction flow (1, 100, 101, 102, 103, 104, 105, 106) and propagating along the flow direction (11), the second chemical element being introduced into the chamber (8) in the confinement gas flow (2) before the interaction zone (14) of each reaction flow.

4. Process according to Claim 3, **characterized in that** the introduction of at least one reaction flow comprises introduction of at least one alignment of several reaction flows (101, 102, 103; 104, 105, 106) separated from one another by the confinement gas flow (2) and each reaction flow comprising the first chemical element and each reaction flow propagating along the flow direction (11).

5. Process according to Claim 4, **characterized in that** the radiation beam (3) propagates along a radiation direction (12) perpendicular to the flow direction (11), and **in that** the flows of each reaction flow alignment (101, 102, 103; 104, 105, 106) are aligned along an alignment direction (18) perpendicular to the flow direction (11) and to the radiation direction (12).

6. Process according to any one of Claims 1 to 5, **characterized in that** the radiation beam (3) propagates along a radiation direction (12) perpendicular to the flow direction (11), and **in that** each reaction flow (1, 100, 101, 102, 103, 104, 105, 106) has, in a plane perpendicular to the flow direction (11), a cross-section extending longitudinally along an elongation direction (13) perpendicular to the flow direction (11) and the radiation direction (12).

7. Process according to any one of the previous claims, **characterized in that** the second chemical element is introduced into the chamber (8) with the first chemical element in each reaction flow (1, 100, 101, 102, 103, 104, 105, 106) before the interaction zone (14) of each reaction flow.

8. Process according to any one of the previous claims, **characterized in that** the first chemical element is introduced into the chamber (8) in the form of SiH₄.

9. Process according to any one of the previous claims, **characterized in that** the cores (15) of particles (10) are of silicon.

10. Process according to any one of the previous claims, **characterized in that** the second element is carbon.

11. Particles each comprising:
- a core (15) comprising as first chemical element non-oxidized silicon, having a diameter comprised between 3 and 900 nm, and
- a layer (16) surrounding the core, consisting solely of a second chemical element of carbon and having a layer thickness of at least 0.5 nm.

12. Device (9) for producing particles (10), comprising:
- a reagent source comprising reagent, this reagent comprising silicon as first chemical element ;
- a reaction chamber (8) connected to the reagent source;
- a reagent injector arranged in order to introduce, into the chamber (8) and originating from the reagent source, at least one reaction flow (1, 100, 101, 102, 103, 104, 105, 106) comprising said reagent and propagating along a flow direction (11) in one reaction flow zone (6) per reaction flow,
- an emitter of a radiation beam arranged in order to project the radiation beam (3) through the reaction chamber (8) intersecting each zone (6) of reaction flow (1, 100, 101, 102, 103, 104, 105, 106) in one interaction zone (14) per reaction flow,
- a source of a second chemical element, and
- an injector of second element arranged in order to introduce, into the reaction chamber (8), the second chemical element from the source of second element so that this second chemical element is able to interact in the chamber (8) with each reaction flow (1, 100, 101, 102, 103, 104, 105, 106),
the reagent (1; 101, 102, 103) being devoid of agent oxidizing the first chemical element, the injector of second element and the injector of first element being arranged together in order to introduce a number of atoms of the second element relative to a number of atoms of the first element in a ratio of one atom of the second element to at least two atoms of the first element, the injector of second chemical element being arranged in order to introduce the second chemical element into the chamber (8) in a gas flow (2 or 7) surrounding each reaction flow (1, 100, 101, 102, 103, 104, 105, 106), **characterized in that**:
- the injector of second chemical element is arranged in order to introduce the second chemical element into the chamber (8) in a peripheral gas flow (7) surrounding each reaction flow (1, 100, 101, 102, 103, 104, 105, 106), emitted from several points (17) distributed along a closed curve surrounding each reaction flow and arranged in order to direct the peripheral gas flow in the direction of each reaction flow, the injector of second chemical element being arranged in order to introduce the second chemical element into the chamber (8) in the peripheral gas flow (7) after the interaction zone (14) of each reaction flow, and/or
- it further comprises a confinement gas injector arranged in order to introduce into the reaction chamber (8), before the interaction zone (14) of each reaction flow, a confinement gas flow (2) surrounding each reaction flow (1, 100, 101, 102, 103, 104, 105, 106) and propagating along the flow direction (11), and **in that** the injector of second chemical element comprises the confinement gas injector.

13. Device according to Claim 12, **characterized in that** the injector of second chemical element is arranged in order to introduce the second chemical element into the chamber (8) in the peripheral gas flow (7) surrounding each reaction flow (1, 100, 101, 102, 103, 104, 105, 106), emitted from several points (17) distributed along the closed curve surrounding each reaction flow and arranged in order to direct the peripheral gas flow in the direction of each reaction flow, the injector of second chemical element being arranged in order to introduce the second chemical element into the chamber (8) in the peripheral gas flow (7) after the interaction zone (14) of each reaction flow.

14. Device according to Claim 12 or 13, **characterized in that** it comprises the confinement gas injector arranged in order to introduce into the reaction chamber (8), before the interaction zone (14) of each reaction flow, the confinement gas flow (2) surrounding each reaction flow (1, 100, 101, 102, 103, 104, 105, 106) and propagating along the flow direction (11), and **in that** the injector of second chemical element comprises the confinement gas injector.

15. Device according to Claim 14, **characterized in that** the injector of at least one reaction flow is arranged in order to introduce into the chamber at least one alignment of several reaction flows (101, 102, 103; 104, 105, 106) separated from one another by the confinement gas flow (2) and each reaction flow comprising the first chemical element and each reaction flow propagating along the flow direction (11).

16. Device according to Claim 15, **characterized in that** the emitter is arranged so that the radiation beam (3) propagates along a radiation direction (12) perpendicular to the flow direction (11), and **in that** the injector of at least one reaction flow is arranged so that the flows of each reaction flow alignment (101, 102, 103; 104, 105, 106) are aligned along an alignment direction (18) perpendicular to the flow direction (11) and the radiation direction (12).

17. Device according to any one of claims 12 to 16, **characterized in that** the emitter is arranged so that the radiation beam (3) propagates along a radiation direction (12) perpendicular to the flow direction (11), and **in that** the injector of at least one reaction flow is arranged so that each reaction flow (1, 100, 101, 102, 103, 104, 105, 106) has, in a plane perpendicular to the flow direction (11), a cross-section extending longitudinally along an elongation direction (13) perpendicular to the flow direction (11) and to the radiation direction (12).

18. Device according to any one of claims 12 to 17, **characterized in that** the injector of second chemical element is arranged in order to introduce the second element into the chamber (8) with the first chemical element in each reaction flow (1, 100, 101, 102, 103, 104, 105, 106) before the interaction zone (14) of each reaction flow.
